(19) Europäisches Patentamt
European Patent Office
Office européen des brevets

(11) Veröffentlichungsnummer: **0 048 221**
**B1**

(12) # EUROPÄISCHE PATENTSCHRIFT

(45) Veröffentlichungstag der Patentschrift: **24.09.86**

(21) Anmeldenummer: **81810372.3**

(22) Anmeldetag: **09.09.81**

(51) Int. Cl.⁴: **H 05 K 1/05,** B 32 B 15/08, B 32 B 15/20, C 08 G 73/10, C 08 G 69/40

(54) **Verwendung von flexiblem Basismaterial zur Herstellung von gedruckten Schaltungen.**

(30) Priorität: **15.09.80 CH 6903/80**

(43) Veröffentlichungstag der Anmeldung: **24.03.82 Patentblatt 82/12**

(45) Bekanntmachung des Hinweises auf die Patenterteilung: **24.09.86 Patentblatt 86/39**

(84) Benannte Vertragsstaaten: **AT CH DE FR GB IT LI NL**

(56) Entgegenhaltungen:
**DE-A-2 726 541**
**GB-A-1 366 490**
**US-A-3 809 591**

**CHEMICAL ABSTRACTS, Band 86, Nr. 22, 30. Mai 1977, Seite 94, Nr. 157218a, Columbus, Ohio, USA**
**Hochtemperaturbeständige Kunststoffe, Karl Hansen Verlag, München, 1979**

(73) Patentinhaber: **CIBA- GEIGY AG, Klybeckstrasse 141, CH- 4002 Basel (CH)**

(72) Erfinder: **Darms, Roland, Dr., Kleinfeldweg 3, CH- 4106 Therwil (CH)**
Erfinder: **Beyeler, Harry, Magnolienpark 18, CH- 4052 Basel (CH)**
Erfinder: **Haug, Theobald, Dr., Untere Flühackerstrasse 12, CH- 4402 Frenkendorf (CH)**



Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. *Der Einspruch ist schriftlich einzureichen und zu begründen. Er gilt erst als eingelegt, wenn die Einspruchsgebühr entrichtet worden* ist (Art. 99(1) Europäisches Patentübereinkommen).

LIBER, STOCKHOLM 1986

**Beschreibung**

Die vorliegende Erfindung betrifft die Verwendung von flexiblem Basismaterial aus mit Polyamiden, Polyimiden und Polyamid-imiden beschichteten Metallfolien zur Herstellung von flexiblen gedruckten Schaltungen.

Flexible gedruckte Schaltungen bieten gegenüber den starren gedruckten Schaltungen bekanntlich viele technische Vorteile. Sie lassen sich besser handhaben, da sie praktisch in jeder Form als elektronisches Bauelement in das System eingefügt werden können, benötigen dadurch weniger Platz im elektrischen Gerät und sind auch unempfindlicher gegenüber Vibrationen.

An das flexible Basismaterial, die mit einem Isolierstoff beschichteten Metallfolie, welche zur Herstellung von gedruckten Schaltungen verwendet wird, werden allerdings hohe Anforderungen gestellt. Die Beschichtung muss eine sehr gute Haftung auf der Metallfolie aufweisen, und die Arbeitsprozesse bei der Herstellung von gedruckten Schaltungen schadlos überstehen, das heisst, die Beschichtung muss eine gut Lötbadbeständigkeit aufweisen sowie eine gute Beständigkeit gegenüber den in der Leiterplattentechnologie eingesetzten Lösungsmitteln. Das flexible Basismatieral muss ferner gebogen, gerollt, verdreht und gefaltet werden können, ohne dass es bei der Beschichtung zur Rissbildung oder Abkantung kommt.

Es ist bekannt, Metallfolien mit Polyimidfolien zu beschichten, indem man die Polyimidfolie auf eine mit einem Bindemittel versehene Kupferfolie aufkaschiert. Solche auf diese Weise hergestellten, eine Bindemittelschicht enthaltenden Laminata erfüllen nicht in jeder Hinsicht die an sie gestellten Anforderungen; insbesonders lassen die elektrischen Eigenschaften dieser Laminata zu wünschen übrig.

Aus US-A- 3,682,960 ist ferner bekannt, Metalle mit einer Mischung aus einer Polyamidsäure und einer mit Amiden modifizierten Polyamidsäure zu beschichten. Die nach Erhitzen auf den Metallen erhaltenen Beschichtungen aus Polyimiden und Polyamidimiden weisen aber den Nachteil auf, dass sie nicht genügend flexibel sind und leicht von der Metallfolie abkanten.

Um diese Nachteile zu umgehen, wird deshalb in US-A- 4,148,969 vorgeschlagen, Laminate aus mit Polyparabansäuren beschichteten Metallfolien zu verwenden, wobei die verwendete Polyparabansäure durch Hydrolyse des Reaktionsproduktes von Diphenylmethandiisocyanat mit Cyanwasserstoff hergestellt wird. Abgesehen davon, dass die Herstellung von der verwendeten Polyparabansäure kompliziert ist, muss man in der Vorstufe mit Cyanwasserstoff arbeiten, wobei zusätzliche Vorsichtsmassnahmen getroffen werden müssen.

Es wurde nun gefunden, dass man auf eine einfachere Art flexible gedruckte Schaltungen erhält, wenn man flexible Basismaterialien aus auf Metallfolien ohne Zwischenschicht fest haftenden Polymerfolien verwendet, die erhalten werden, indem man die Metallfolie mit einem Pulver, einer Folie oder einer organischen Lösung eines Polyamids, einer Polyamidsäure oder Polyamidamidsäure beschichtet und die beschichtete Metallfolie unter Schmelzen des Pulvers bzw. unter Verdampfung des organischen Lösungsmittels auf höhere Temperaturen erhitzt.

Gegenstand der vorliegenden Erfindung ist somit die Verwendung von flexiblem Basismaterial zur Herstellung von flexiblen gedruckten Schaltungen, wobei das Basismaterial aus einer ohne Zwischenschicht mit einem Polymeren beschichteten Metallfolie besteht dadurch gekennzeichnet, dass die Polymer-Beschichtung aus einem Polyamid, Polyamid-imid und/oder Polyimid besteht und erhalten wird, indem man Polyamide, Polyamid-amidsäuren und/oder Polyamidsäuren, die aus 1 bis 100 Mol-% Strukturelementen der Formel I

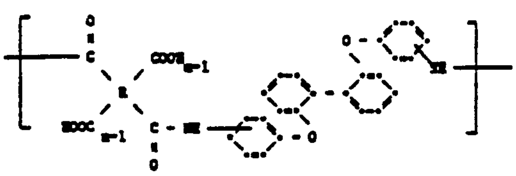

(I)

und aus 0 bis 99 Mol.% Strukturelementen der Formel II

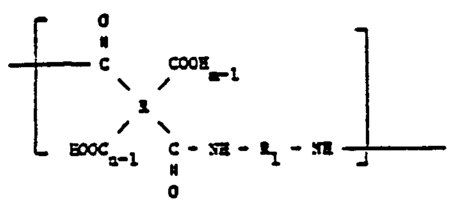

(II)

bestehen, worin die NH-Gruppen in Formel I unabhängig voneinander in o-, m- oder p-Stellung an den Benzolkern gebunden sind und die einzelnen m, n, R und $R_1$, unabhängig voneinander das folgende bedeuten:

m und n die Zahl 1 oder 2,

R einen carbocyclisch-aromatischen oder heterocyclisch-aromatischen Rest, wobei die Carbonamid- und Carboxylgruppen an verschiedene Kohlenstoffatome gebunden sind und sich die Carboxylgruppen, falls R einen cyclischen Rest und mindestens eines von m und n die Zahl 2 bedeuten, je in ortho-Stellung zu einer Carbonamidgruppe befinden, und $R_1$ einen carbocyclisch-aromatischen oder heterocyclisch-aromatischen Rest, sowie die gegebenenfalls zum entsprechenden Imid cyclisierten Derivate auf Temperaturen zwischen 50 bis 350° C erhitzt.

Vorzugsweise verwandet man Basismaterial,

wobei die beschichtete als Metallfolie eine Kupferfolie ist.

Die auf der Metallfolie fast haftende Beschichtung besteht vorzugsweise aus einem Polyamid, Polyamid-imid und/oder Polyimid, die aus einem Polyamid, einer Polyamid-amidsäure oder Polyamidsäure mit den Strukturelementen der Formeln I und II erhalten wird, worin in der Formel I die beiden NH-Gruppen in p-Stellung an den Benzolkern gebunden sind, R und $R_1$ aromatische Reste darstellen und m und n die Bedeutung wie in Formel I und II haben.

Insbesonders bestehen die Beschichtungen aus einem Polyamid, Polyamidimid und/oder Polyimid, die aus einem Polyamid, einer Polyamid-amidsäure oder Polyamidsäure mit den Strukturelementen der Formeln I und II erhalten werden, worin R bei m und n = 2 einen Benzolring oder das Benzophenonringsystem und bei m und n = 1 den Benzolring und $R_1$ die 1,3- oder 1,4-Phenylengruppe, den 4,4'-Diphenyläther-, 4,4'-Diphenylmethan- oder 4,4'-Diphenylsulfonrest bedeuten, oder aus den zu den entsprechenden Imiden cyclisierten Derivaten.

In einer bevorzugten Ausführungsform verwendet man Basismaterial, wobei die Beschichtung aus einem Polyamid, bestehend aus 100 Mol-% des Strukturelementes der Formel I, worin m und n = 1 sind und R für 1,3-und/oder 1,4- Phenylen steht, besteht.

In einer besonders bevorzugten Ausführungsform verwendet man Basismaterial, wobei die Beschichtung aus einem Polyamid, bestehend aus 1 bis 40 Mol-% Strukturelementen der Formel I und aus 60 bis 99 Mol-% Strukturelementen der Formel II, worin m und n = 1, R den Benzolring und $R_1$ die 1,3- oder 1,4-Phenylengruppe bedeuteten, besteht.

In einer weiteren besonderen Ausführungsform verwendet man Basismaterial, wobei die Beschichtung aus einer Polyamidsäure, enthaltend 1 bis 20 Mol-% der Strukturelemente der Formel I und 80-99 Mol-% der Strukturelemente der Formel II, worin m und n = 2, R einen Benzolring oder das Benzophenonringsystem und $R_1$ den 4,4'-Diphenyläther-, 4,4'-Diphenylmethan-oder 4,4'-Diphenylsulfonrest bedeuten, oder aus dem zu den entsprechenden Imiden cyclisierten Derivaten besteht.

Die erfindungsgemäss verwendeten flexiblen Basismaterialien werden erhalten, indem man eine Metallfolie, vorzugsweise eine Cu-Folie, mit einem Pulver, einer Folie oder einer organischen Lösung eines Polyamids, einer Polyamidamidsäure und/oder Polyamidsäure mit den Strukturelementen der Formel I und II oder der gegebenenfalls zu den entsprechenden Imiden cyclisierten Derivaten beschichtet und die beschichtete Metallfolie auf Temperaturen zwischen 50 bis 350°C erhitzt. Die zum Beschichten der Metallfolien verwendeten Polyamide, Polyamid-amidsäuren und Polyamidsäuren sowie die entsprechenden zum Imid cyclisierten Derivate sind aus der DE-A- 2 726 541 bekannt und können dadurch hergestellt werden, indem man 1-100 Mol-% eines Diamins der Formel III

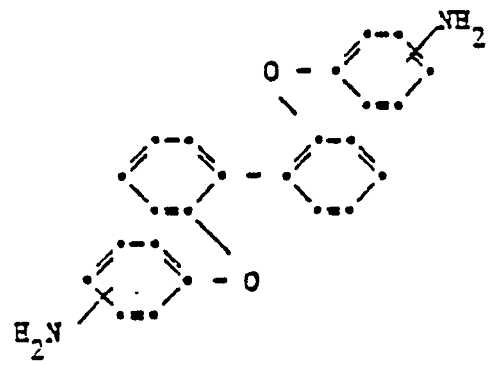

(III),

in der sich die $NH_2$-Gruppen unabbhängig voneinander in o-, m- oder p-Stellung des Benzolkerns befinden, und 0-99 Mol-% eines Diamins der Formel IV

$$H_2N - R_1 - NH_2 \qquad (IV)$$

mit im wesentlichen stöchiometrischen einer Verbindung der Formel V

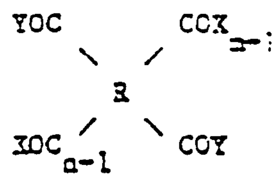

(V),

worin m, n, R und $R_1$ die gleiche Bedeutung wie in den Formeln I und II haben und

X bei m und/oder n = 2, zusammen mit Y die Gruppierung -O- bildet,

Y ein Chloratom, eine Hydroxylgruppe, eine unsubstituierte oder substituierte Phenoxygruppe oder eine Alkoxygruppe mit 1-18, besonders 1-12 Kohlenstoffatomen darstellt, oder Y, wenn m und/oder n = 2, zusammen mit X die Gruppierung -O- bildet, wobei die Gruppen -COY und -COX an verschiedene Kohlenstoffatome gebunden sind und sich die -COY-Gruppe oder -Gruppen, wenn R einen cyclischen Rest darstellt, und m und/oder n = 2, in ortho-Stellung zu einer -COX-Gruppe befinden, kondensiert und die erhaltenen Polymeren, worin m und/oder n = 2, gegebenenfalls anschliessend zum Imid cyclisiert.

Die verwendeten Polyamide, Polyamid-amidsäuren und Polyamidsäuren weisen im allgemeinen eine inhärente Viskosität in N,N-Dimethylacetamid (DMA) bei 25°C von etwa 0,4 bis 4,0 dl/g, insbesondere von 0,7 bis 2,5 dl/g auf. Die inhärente Viskosität der cyclisierten Derivate,

d.h. der Polyamid-imide und Polyimide, in konz. $H_2SO_4$ oder DMA bei 25° C liegt in derselben Grössenordnung.

Die inhärente Viskosität $\eta_{inh.}$, die ein Mass für das Molekulargewicht eines Polymeren darstellt, berechnet sich nach folgender Gleichung:

$$\eta_{inh.} = \frac{\ln \frac{\eta}{\eta_o}}{c}$$

worin

ln = natürlicher Logarithmus,

$\eta$ = Viskosität der Lösung (0,5 Gew.-% des Polymeren in einem geeigneten Lösungsmittel, z.B. N,N-Dimethylacetamid, N,N-Dimethylformamid, N-Methylpyrrolidon),

$\eta_o$ = Viskosität des Lösungsmittels und

c = Konzentration der Polymerlösung in g Polymer/100 ml Lösungsmittel bedeuten.

Die Viskositätsmessungen erfolgen bei 25° C. Wie allgemein bekannt ist, stellt die inhärente Viskosität ein Mass für dass Molekulargewicht eines Polymeren dar. Die angeführten Werte von $\eta_{inh.}$ = 0,4 bis 4,0 entsprechen den mittleren Molekulargewichten von etwa 5000 bis 50000. Die mittleren Molekulargewichte können nach an sich bekannten Methoden, z.B. mittels Lichtstreuung, bestimmt werden.

Bei den verwendeten Polymeren kann es sich um Homopolymere oder um Copolymere mit statistischer Verteilung der einzelnen Strukturelemente der Formeln I und II handeln. In den einzelnen Strukturelementen können die m, n, R und $R_1$ zudem unterschiedliche Bedeutung haben. Es kann sich aber auch um Copolymere mit beliebiger, mindestens teilweise blockartiger Anordnung definitionsgemässer Polyamid-, Polyamid-amidsäureoder Polyamidsäure-Strukturelemente der Formeln I und II handeln. Derartige Copolymere können z.B. dadurch erhalten werden, dass man zuerst ein Diamin der Formel III mit einem leichten Ueberschuss eines bestimmten Di-, Tri- oder Tetracarbonsäurederivats der Formel V reagieren lässt, z.B. einem Dicarbonsäurederivat und dann dem Reaktionsgemisch ein anderes Di-, Tri- oder Tetracarbonsäurederivat der Formel V, ein Diamin der Formel IV und/oder weiteres Diamin der Formel III zusetzt.

Die allfällige Cyclisierung der nach der Kondensation anfallenden Polyamidsäuren oder Polyamid-amidsäuren (mit Strukturelementen der Formel I und II mit m und/oder n = 2) erfolgt in an sich bekannter Weise chemisch oder thermisch.

Die chemische Cyclisierung wird zweckmässig durch Behandlung mit einem Dehydratisierungsmittel ellein oder im Gemisch mit einem tertiären Amin vorgenommen. In Frage kommen z.B. Essigsäureanhydrid, Propionsäureanhydrid und Dicyclohexylcarbodiimid oder Gemisch von Essigsäureanhydrid und Triäthylamin.

Die thermische Cyclisierung wird durch Erhitzen auf Temperaturen von etwa 50 bis 300° C, vorzugsweise etwa 150 bis 250° C und gegebenenfalls unter Zusatz eines inertan organischen Lösungsmittels vorgenommen.

Aus der genannten DE-A- 2 726 541 geht ferner hervor, dass sich die Polyamide, Polyamidsäuren und Polyamid-amidsäuren zur Herstellung von Folien, Ueberzugsmassen, Verbundswerkstoffen und als Laminierharze eignen, doch lässt sich kein Hinweis entnehmen, dass sich die mit den Polymeren beschichteten Metallfolien äusserst flexibel verhalten, das heisst, ein wiederholtes Biegen und Falten ohne Rissbildung im Polymerfilm überstehen und ausserdem eine gute Lötbadsbeständigkeit sowie eine gute Beständigkeit gegenüber den in der Leiterplattentechnologie eingesetzten Lösungsmitteln aufweisen.

Die verwendeten Polyamide, Polyamid-amidsäuren und Polyamidsäuren, die vorzugsweise in einem wasserfreien organischen Lösungsmittel und unter Feuchtigkeitsausschluss hergestellt werden, werden vorteilhaft in Form dieser organischen Lösungen verarbeitet. Geeignete organische Lösungsmittel sind: N,N-Dimethylacetamid, N,N-Diäthylacetamid, N,N-Dimethylformamid, N,N-Dimethylmethoxyacetamid, N-Methyl-2-pyrrolidon, N-Acetyl-2-pyrrolidon, N-Methyl-ε-caprolactam, Hexamethylphosphorsäuretriamid (Hexametapol), N,N,N',N'-Tetramethylharnstoff, Tetrahydrothiophendioxid (Sulfolan) und Dimethylsulfoxid.

Es können auch Gemische solcher Lösungsmittel verwendet werden. Andererseits ist es auch möglich, diese bevorzugten Lösungsmittelsysteme mit anderen organischen aprotischen Lösungsmitteln, wie aromatischen, cycloaliphatischen oder aliphatischen, gegebenenfalls chlorierten Kohlenwasserstoffen, beispielsweise Benzol, Toluol, Xylolen, Cyclohexan, Pentan, Hexan, Petroläther, Methylenchlorid, Tetrahydrofuran, Cyclohexanon und Dioxan, zu verdünnen.

Um die Lagerstabilität der organischen Lösung der eingesetzten Polymeren zu erhöhen, ist es zweckmässig, der Lösung eine wasserabsorbierende Substanz, wie zum Beispiel ein Molekularsieb, zuzugeben. Molekularsiebe werden vorteilhaft in Mengen von etwa 10 Gewichtsprozent, bezogen auf die Menge der organischen Lösung, zugesetzt. Molekularsiebe sind im Handel erhältlich, zum Beispiel als Handelsprodukte der Firma Merck.

Ueberraschenderweise wurde weiterhin gefunden, dass es vorteilhaft ist, den organischen Beschichtungslösungen, die bei höheren Temperaturen oder maschinell verarbeitet werden, vor der Verarbeitung ein Fliessmittal, z.B. "Modaflow" (Handelsprodukt der Firma Monsanto), zuzugeben.

Die Beschichtung der Metallfolien mit den

organischen Polymer-Lösungen kann sowohl von Hand als auch mit Beschichtungsmaschinen vorgenommen werden. Es können auch vertikale Beschichtungsmaschinen eingesetzt werden. Bei der maschinellen Beschichtung ist es lediglich wichtig, dass eine klebfreie Beschichtung auf der Metallfolie erhalten wird, so dass dieser Schichtstoff sich gewünschtenfalls aufrollen lässt. Zur Erzielung optimaler Eigenschaften kann dieser Schichtstoff nachträglich auf höhere Temperaturen z.B. 4 Stunden auf 180°C und 2 Stunden auf 250°C, erhitzt werden, wobei praktisch eine vollständige Cyclisierung der Amidsäuregruppen zu den Imidgruppen eintritt.

Zum Beschichten der Metallfolien können die verwendeten Polyamide, Polyamid-amidsäuren und Polyamidsäuren sowie die gegebenenfalls zum Imid cyclisierten Derivate auch in Form von Pulvern oder Folien eingesetzt werden, die dann auf die Metallfolien aufgeschmolzen werden.

Die auf diese Weise Beschichteten Metallfolien können direkt zu Herstellung von gedruckten Schaltungen verwendet werden, indem man die auf der Metallseite mit einem Photolack versehene Folie durch eine Photomaske belichtet und die belichtete Metallfolie in bekannter Weise entwickelt. Dabei werden flexible, gedruckt Schaltungen mit hoher mechanischer Festigkeit erhalten.

**Beispiel 1**

**A) Herstellung eines Polyamids**

In einem Sulfierkolben, versehen mit Rührer, Innenthermometer, Tropftrichter, Gaseinleitungsrohr und Druckausgleichgefäss, werden unter Stickstoff 22,80 g (0,062 Mol) 2,2'-Di-(p-aminophenoxy)-diphenyl in 100 g wasserfreiem N,N-Dimethylacetamid unter Rühren bei 40°C - 50°C klar gelöst. Die Lösung wird auf -5°C abgekühlt und unter heftigem Rühren werden 12,58 g (0,062 Mol) Isophthalsäuredichlorid bei -5°C bis 0°C von 30 Minuten eingetragen, wobei das Reaktionsgemisch zusehends viskos und hellbeige wird. Anschliessend wird noch 30 Minuten ausreagieren gelassen. Dann werden 12,55 g (0,124 Mol) Triäthylamin während 30 Minuten bei 0°C bis 5°)sC zugetropft und eine weitere Stunde bei 0°C bis 5°C ausreagieren gelassen. Das Reaktionsgemisch wird mit 22 g wasserfreiem N,N-Dimethylacetamid verdünnt und homogen gemischt. Das ausgefallene Triäthylaminhydrochlorid wird durch eine Glasfritte abgenutscht und der Filterkuchen wird mit 20 g wasserfreiem N,N-Dimethylacetamid nachgewaschen. Man erhält eine Klare viskose Lösung mit einer inhärenten Viskosität von 0,98 dl/g bei 25°C (c = 0,5 % in N,N-Dimethylacetamid), die direkt zum Beschichten von Cu-Folien verwendet werden kann.

**B) Beschichtung von Cu-Folien und Herstellung einer gedruckten Schaltung**

Die oben erhaltene Polyamidlösung wird gleichmässig mit einer Rakel auf Cu-Folien verteilt und die Beschichtungen werden bei 70°C-150°C/ 20 mbar 7 Stunden vorgetrocknet und dabei vom Lösungsmittel befreit. Die Laminate werden anschliessend während 10 Stunden bei 200°C/0,10 mbar einer chermischen Behandlund unterzogen. Man erhält gut haftende, transparente, flexible Ueberzuge auf der Cu-Folie.

Zur Herstellung einer gedruckten Schaltung wurde das Laminat auf der Cu-Seite mit einem Photolack beschichtet, durch eine Photomaske belichtet, in einem chlorierten Lösungsmittel entwickelt und in $FeCl_3$ geätzt. Es resultierte eine flexible gedruckte Schaltung mit ausgezeichneter Haftung der Leiterbahnen.

**Patentansprüche**

1. Verwendung von flexiblem Basismaterial zur Herstellung von flexiblen gedruckten Schaltungen, wobei das Basismaterial aus einer ohne Zwischenschicht mit einem Polymeren beschichteten Metallfolie besteht, dadurch gekennzeichnet, dass die Polymer-Beschichtung aus einem Polyamid, Polyamid-imid oder Polyamid besteht und erhalten wird, indem man Polyamide, Polyamid-amidsäuren oder Polyamidsäuren, die aus 1 bis 100 Mol-% Strukturelementen der Formel I

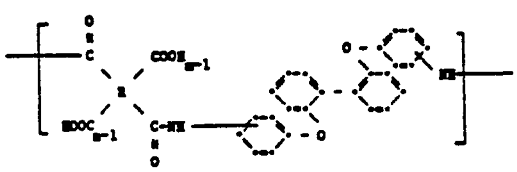
(I)

und aus 0 bis 99 Mol.% Strukturelementen der Formel II

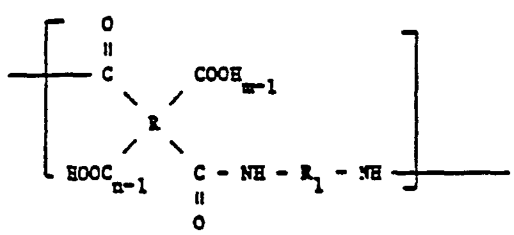
(II)

bestehen, worin die NH-Gruppen in Formel I unabhängig voneinander in o-, m- oder p-Stellung an den Benzolkern gebunden sind und die einzelnen m, n, R und $R_1$ unabhängig voneinander das folgende bedeuten:

m und n die Zahl 1 oder 2, R einen carbocyclisch-aromatischen oder heterocyclisch-aromatischen Rest, wobei die Carbonamid- und Carboxylgruppen an verschiedene Kohlenstoffatome gebunden sind und sich die Carboxyl-gruppen, falls R einen cyclischen Rest und mindestens eines von m und n die Zahl 2 bedeuten, je in ortho-Stellung zu einer Carbonamidgruppe befinden, und $R_1$ einen carbocyclisch-aromatischen oder heterocyclisch-aromatischen Rest, sowie die gegebenenfalls zum entrsprechenden Imid cyclisierten Derivate auf Temperaturen zwischen 50 bis 350° C erhitzt.

2. Verwendung gemäss Anspruch 1, dadurch gekennzeichnet, dass die beschichtete Metallfolie eine Kupferfolie ist.

3. Verwendung gemäss Anspruch 1, dadurch gekennzeichnet, dass die Polymer-Beschichtung aus einem Polyamid, einer Polyamid-amid-säure oder Polyamidsäure mit den Strukturelementen der Formeln I und II besteht, worin in Formel I die beiden NH-Gruppen in p-Stellung an den Benzolkern gebunden sind, R und $R_1$ aromatische Reste darstellen und m und n die Bedeutung wie im Anspruch 1 haben.

4. Verwendung gemäss Anspruch 1 oder 3, dadurch gekennzeichnet, dass die Polymer-Beschichtung aus einem Polyamid, einer Polyamid-amidsäure oder Polyamidsäure mit den Strukturelementen der Formeln I und II besteht, worin R bei m und n = 2 einen Benzolring oder das Benzophenonringsystem und bei m und n = 1 Benzolring und $R_1$ die 1,3- oder 1,4-Phenylengruppe, den 4,4'-Diphenyläther-, 4,4'-Diphenylmethan- oder 4,4'-Diphenylsulfonrest bedeuten, oder aus den zu den entsprechenden Imiden cyclisierten Derivaten.

5. Verwendung gemäss Anspruch 1 oder 3, dadurch gekennzeichnet, dass die Polymer-Beschichtung aus einem Polyamid, bestehend aus 100 Mol-% des Strukturelementes der Formel I, worin m und n = 1 sind vad R für 1,3-und/oder 1,4-Phenylen steht, besteht.

6. Verwendung gemäss Anspruch 1 oder 3 dadurch gekennzeichnet, dass die Polymer-Beschichtung aus einem Polyamid, das aus 1 bis 40 Mol-% Strukturelementen der Formel I und aus 60 bis 99 Mol-% Strukturelementen der Formel II besteht, worin m und n = 1, R den Benzolring und $R_1$ die 1,3- oder 1,4-Phenylengruppe bedeuten, besteht.

7. Verwendung gemäss Anspruch 1 oder 3, dadurch gekennzeichnet, dass die Polymer-Beschichtung aus einer Polyamidsäure, enthaltend 1 bis 20 Mol-% Strukturelemente der Formel I und 80-99 Mol-% Strukturelemente der Formel II, worin m und n = 2, R einen Benzolring oder das Benzophenonringsystem und $R_1$ den 4,4'-Diphenyläther-, 4,4'-Diphenylmethan- oder 4,4'-Dipheylsulfonrest bedeuten, oder aus den zu den entsprechenden Imiden cyclisierten Derivaten besteht.

8. Verwendung gemäss Anspruch 1, dadurch gekennzeichnet, dass man zum Beschichten eine mit einer wasserabsorbierenden Substanz stabilisierte Lösung eines Polyamids, einer Polyamid-amidsäure und/oder Polyamisäure mit den Strukturelementen der Formeln I und II verwendet.

9. Verwendung gemäss Anspruch 1, dadurch gekennzeichnet, dass man zum Beschichten eine organische Lösung eines Polyamids, einer Polyamidamidsäure und/oder Polyamidsäure mit den Strukturelementen der Formeln I und II verwendet, welche zusätzlich ein Fliessmittel enthält.

## Claims

1. Use of a flexile base material for the production of flexible printed circuits said base material consisting of a metal foil coated with a polymer without an intermediate layer wherein the polymer coating consists of a polyamide polyamide-imide or polyimide and is obtained by heating a polyamde polyamide-amide acid or polyamde acid which consists of 1 to 100 ml % of structural units of the formula I

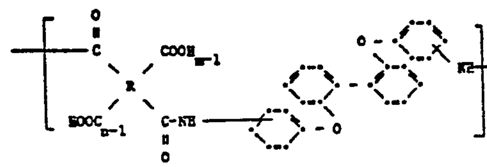

(I)

and of 0 to 99 mol % of structural of the formula II

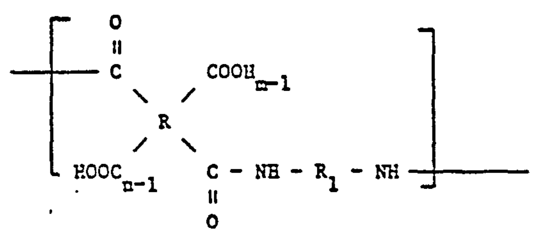

(II)

in which the NH groups in formula I are independently of one another attached to the o- m- or p-position of the benzene nucleus and the individual symbols m, n, R and $R_1$ independently of one another are defined as follows:

m and n are each 1 or 2,

R is a carbocyclic-aromatic or heterocyclic-aromatic radical, in which the carbamoyl groups and carboxyl groups are attached to different carbon atoms and the carboxyl groups, if R is a cyclic radical and at least one of m and n is 2, are each in the ortho-position to a carbamoyl group, and

$R_1$ is a carbocyclic-aromatic or heterocyclic-aromatic radical,

and any derivative obtained by cyclisation to

the corresponding imide, to temperatures in the range from 50° to 350° C.

2. Use according to, claim 1, wherein the coated metal foil is a copper foil.

3. Use according to claim 1, wherein the polymer coating consists of a polyamide, a polyamide-amide acid or a polyamide acid containing the structural units of the formulae I and II, in which, in formula I, the two NH groups, are bonded to the benzene nucleus in the p-position, R and $R_1$ are aromatic radicals and m and n are as defined in claim 1.

4. Use according to either of claims 1 or 3, wherein the polymer coating consists of a polyamide, a polyamide-amide acid or polyamide acid containing structural units of the formulae I and II, in which R, if m and n = 2, is a benzene ring or the benzophenone ring system and, if m and n = 1, is a benzene ring, and $R_1$ is a 1,3- or 1,4-phenylene group, or a 4,4' -diphenyl ether, 4,4'-diphenylmethane or 4,4' -diphenylsulfone radical, or of a derivative obtained by cyclisation to the corresponding imide.

5. Use according to either of claims 1 or 3, wherein the polymer coating consists of a polyamide containing 100 mol % of the structural units of the formula I, in which m and n = 1 and R is 1,3-phenylene and/or 1,4-phenylene.

6. Use according to either of claims 1 or 3, wherein the polymer coating consists of a polyamide which contains 1 to 40 mol % of structural units of the formula I and 60 to 99 mol % of structural units of the formula II, in which m and n = 1, R is a benzene ring and $R_1$ is a 1,3-phenylene or 1,4-phenylene group.

7. Use according to either of claims 1 or 3, wherein the polymer coating consists of a polyamide acid which consists of 1 to 20 mol % of structural units of the formula I and of 80 to 99 mol % of structural units of the formula II, in which m and n = 2, R is a benzene ring or the benzophenone ring system and $R_1$ is a 4,4'-diphenyl ether, 4, 4' -diphenylmethane or 4,4' -diphenylsulfone radical, or of a derivative obtained by cyclisation to, the corresponding imide.

8. Use according to claim 1, wherein a solution of a polyamide, a polyamide-amide acid and/or a polyamide acid containing the structural units of the formulae I and II, which solution is stabilised with a water-absorbing substance, is used for coating.

9. Use according to claim 1, wherein an organic solution of a poyamide, a polyamide- amide acid and/or a polyamide acid, containing the structural units of the formulae I and II, which solution additionally contains a flow control agent, is used for coating.

**Revendications**

1. Application d'un matériau de base souple à la fabrication de circuits imprimés souples, ledit matériau de base étant constitué d'une feuille métallique revêtue, sans couche intermédiaire, d'un polymère, application caractérisée en ce que le revêtement de polymère est constitué d'un polyamide, d'un polyamide-imide ou d'un polyimide et a été obtenu par chauffage, à des températures comprises entre 50 et 350 C, de polyamides, de polyamide-amide-acides et/ou de polyamide-acides constitués de 1 à 100 % en moles d'unités structurales de formule I:

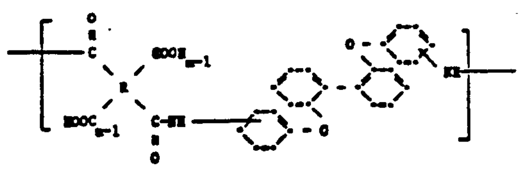

(I)

et de 0 à 99 % en moles d'unités structurales de formule II:

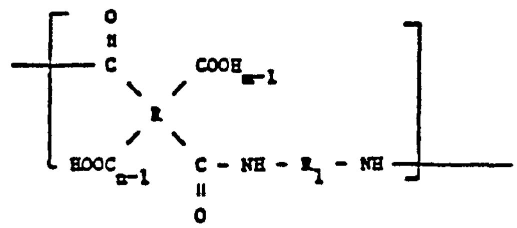

(II),

formules dans lesquelles les radicaux -NH- (pour la formule I) sont fixés, indépendamment les uns des autres, en position ortho, méta ou para sur le noyau benzénique et les divers symboles m, n, R et $R_1$ ont chacun, indépendamment les uns des autres, les significations suivantes:

m et n sont égaux chacun à 1 ou à 2, R représente un radical carbocyclique-aromatique ou hétérocyclique-aromatique qui porte les radicaux carbamoyles et carboxy sur des atomes de carbone différents et sur lequel, lorsque R est un radical cyclique et qu'au moins l'un des symboles m et n est égal à 2, les radicaux carboxy sont chacun en ortho par rapport à un radical carbamoyle, et

$R_1$ représente un radical carbocyclique-aromatique ou hétérocyclique-aromatique,

ainsi que des dérivés éventuellement cyclisés en les imides correspondants.

2. Application selon la revendication 1 caractérisée en ce que la feuille métallique revêtue est une feuille de cuivre.

3. Application selon la revendication 1 caractérisée en ce que le revêtement de polymère est constitué d'un polyamide, d'un polyamide-amide-acide ou d'un polyamide-acide

comportant des unités structurales de formules I et II dans lesquelles les radicaux -NH-, pour la formule I, sont chacun en position para sur leur noyau benzénique, R et $R_1$ représentent chacun un radical aromatique, tandis que m et n ont les significations données dans la revendication 1.

4. Application selon l'une des revendications 1 et 3, caractérisée en ce que le revêtement de polymère est constitué d'un polyamide, d'un polyamide-amide-acide ou d'un polyamide-acide comportant des unités structurales de formules I et II dans lesquelles R, dans le cas où m et n sont égaux à 2, représente un noyau benzénique ou le système cyclique de la benzophénone et, dans le cas où m et n sont égaux à 1, un noyau benzénique, et $R_1$ représente un radical phénylène-1,3, phénylène-1,4, phénoxybenzène-4,4', diphénylméthane-4,4' ou diphénylsulfone-4,4', ou est constitué des dérivés cyclisés en les imides correspondants.

5. Application selon l'une des revendications 1 et 3, caractérisée en ce que le revêtement de polymère est constitué d'un polyamide renfermant 100 % en moles d'unités structurales de formule I dans lesquelles m et n sont égaux à 1 et R représente un radical phénylène-1,3 et/ ou phénylène-1,4.

6. Application selon l'une des revendications 1 et 3, caractérisée en ce que le revêtement de polymère est constitué d'un polyamide renfermant de 1 à 40 % en moles d'unités structurales de formule I et de 60 à 99 % en moles d'unités structurales de formule II, formules dans lesquelles m et n sont égaux à 1, R représente un noyau benzénique et $R_1$ représente un radical phénylène-1,3 ou phénylène-1,4.

7. Application selon l'une des revendications 1 et 3, caractérisée en ce que le revêtement de polymère est constitué d'un polyamide-acide contenant de 1 à 20 % en moles d'unités structurales de formule I et de 80 à 99 % en moles d'unités structurales de formule II, formules dans lesquelles m et n sont égaux à 2, R représente un noyau benzénique ou le système cyclique de la benzophénone, et $R_1$ représente un radical phénoxybenzène-4,4', diphénylméthane-4,4' ou diphénylsulfone-4,4', ou est constitué des dérivés cyclisés en les imides correspondants.

8. Application selon la revendication 1 caractérisée en ce qu'on utilise, pour l'enduction, une solution d'un polyamide, d'un polyamide-amide-acide et/ou d'un polyamide-acide renfermant des unités structurales de formules I et II, solution qui a été stabilisée par une substance absorbant l'eau.

9. Application selon la revendication 1 caractérisée en ce qu'on utilise, pour l'enduction, une solution organique d'un polyamide, d'un polyamide-amide-acide et/ou d'un polyamide-acide renfermant des unités structurales de formules I et II, solution qui contient en outre un agent d'écoulement.